# EUROPEAN PATENT APPLICATION

(11) **EP 4 838 869 A1**
(43) Date of publication of application: **11.11.2026**
(21) Application number: 24924128.2
(22) Date of filing: 27.12.2024
(51) Int. Cl.: H04M 1/02, H04R 1/28, H05K 9/00, H04M 1/03, H01Q 1/24

(54) **ELECTRONIC DEVICE COMPRISING FLOATING GROUND CONNECTED TO CASE FOR SPEAKER**

(30) Priority: 08.02.2024 KR 20240019873; 03.04.2024 KR 20240045603
(71) Applicant: Samsung Electronics Co., Ltd., Suwon-si, Gyeonggi-do 16677 (KR)
(72) Inventor: KIM, Taehun, Suwon-si Gyeonggi-do 16677 (KR); MIN, Ungki, Suwon-si Gyeonggi-do 16677 (KR); HAN, Kwanhee, Suwon-si Gyeonggi-do 16677 (KR); PARK, Jihoon, Suwon-si Gyeonggi-do 16677 (KR); BYUN, Kangwook, Suwon-si Gyeonggi-do 16677 (KR); YE, Sangmin, Suwon-si Gyeonggi-do 16677 (KR); HAM, Jonghee, Suwon-si Gyeonggi-do 16677 (KR)
(74) Representative: Gulde & Partner
(86) International application number: PCT/KR2024/021361
(87) International publication number: WO 2025/170187

(57) **Abstract**

This electronic device comprises: a speaker; a PCB including an opening portion in which the speaker is accommodated; a capacitor disposed on the PCB; and a case surrounding the rear surface of the speaker and disposed on the PCB, wherein the PCB includes: a conductive pad disposed on the PCB along the periphery portion of the opening portion and coupled to the case; conductive patterns on a layer of the PCB on which the conductive pad is disposed, the conductive patterns being spaced apart from the conductive pad, and the capacitor may reduce a current flowing from a component on the PCB to a rechargeable battery through the case, and may connect the conductive patterns and the conductive pad so that the case operates as a ground while the electronic device transmits a signal to an external electronic device.

## Description

### [Technical Field]

The present disclosure relates to an electronic device including a floating ground connected to a case for a speaker.

### [Background Art]

In a case of a small and thin electronic device, a thickness and a size of components disposed in the electronic device may be limited. For miniaturization of the electronic device, it may be necessary to reduce the size of individual electronic components and optimize a disposition structure. It may be necessary to provide a structure for reducing noise caused by electromagnetic interference between the electronic components while optimizing the disposition structure.

The above-described information may be provided as a related art for the purpose of helping understanding of the present disclosure. No claim or determination is raised as to whether any of the above-described descriptions may be applied as a prior art related to the present disclosure.

### [Disclosure]

### [Technical Solution]

An electronic device is disclosed. The electronic device may include a rechargeable battery. The electronic device may include a speaker. The electronic device may include a printed circuit board including an opening portion accommodating the speaker. The electronic device may include a component on the printed circuit board disposed adjacent to the speaker. The electronic device may include at least one element disposed on the printed circuit board. The electronic device may include a case surrounding a rear side of the speaker and disposed on the printed circuit board. The printed circuit board may include a conductive pad disposed along a peripheral portion of the opening portion and coupled to the case. The printed circuit board may include conductive patterns spaced apart from the conductive pad and disposed on a layer of the printed circuit board on which the conductive pad is disposed. The at least one element may connect the conductive patterns and the conductive pad for the case functioning as a ground.

An electronic device is disclosed. The electronic device may include a speaker. The electronic device may further include a printed circuit board (PCB). The PCB may include an opening portion accommodating the speaker. The electronic device may further include at least one element. The at least one element may be disposed on the PCB. The electronic device may further include a case. The case may surround a rear side of the speaker and may be disposed on the PCB. The PCB may include a conductive pad disposed along the opening portion, exposed to an outside of the PCB, and coupled to the case. The PCB may include conductive patterns disposed in the PCB and spaced apart from the conductive pad. The conductive pad may be connected, through the at least one element, to the conductive patterns electrically connected to a ground portion of the electronic device. By the at least one element, the conductive pad may be electrically disconnected from the conductive patterns in a first frequency band and electrically connected to the conductive patterns in a second frequency band higher than the first frequency band.

### [Description of the Drawings]

FIG. 1 is a diagram illustrating an electronic device according to an embodiment.
FIG. 2 is an exploded perspective view of an electronic device according to an embodiment.
FIG. 3 is a diagram illustrating an interior of an exemplary electronic device.
FIG. 4 is a cross-sectional view of an exemplary electronic device.
FIGS. 5A, 5B, and 5C are exemplary diagrams illustrating a periphery of an opening portion on which a speaker of each of layers of a printed circuit board is mounted.
FIG. 5D is an exemplary diagram illustrating a layer from which a conductive portion of a printed circuit board is partially removed.
FIG. 6 is a cross-sectional view of an exemplary electronic device including a capacitor connecting a conductive pad and conductive patterns.
FIG. 7 is an exemplary diagram illustrating a periphery of an opening portion of a printed circuit board including a capacitor connecting a conductive pad and conductive patterns.
FIG. 8 is a block diagram of an electronic device in a network environment according to various embodiments.

### [Mode for Invention]

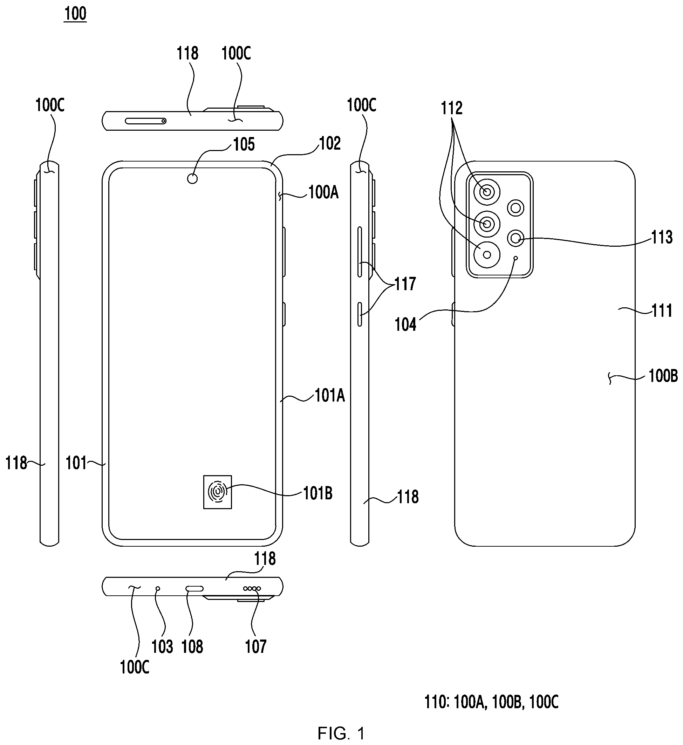

FIG. 1 is a diagram illustrating an electronic device according to an embodiment.

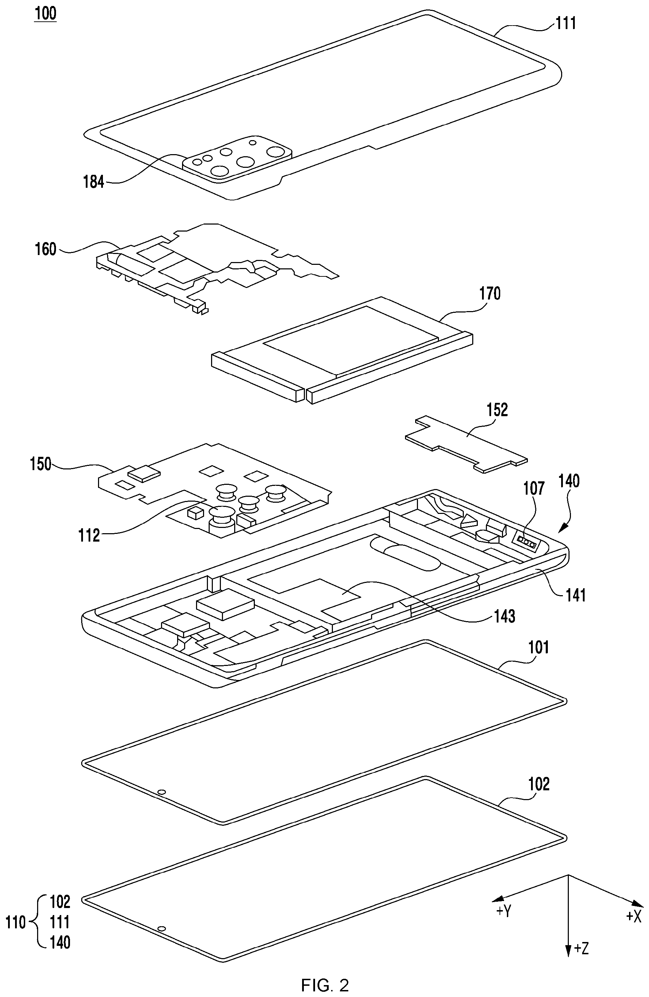

Referring to FIG. 1, an electronic device 100 according to an embodiment may include a housing 110 forming an exterior of the electronic device 100. For example, the housing 110 may include a first side (or a front side) 100A, a second side (or a rear side) 100B, and a third side (or a lateral side) 100C covering a space between the first side 100A and the second side 100B. In an embodiment, the housing 110 may refer to a structure (e.g., a frame structure 140 of FIG. 2) forming at least a portion of the first side 100A, the second side 100B, and/or the third side 100C.

The electronic device 100 according to an embodiment may include a substantially transparent front plate 102. In an embodiment, the front plate 102 may form at least a portion of the first side 100A. In an embodiment, the front plate 102 may include, for example, a glass plate or a polymer plate including various coating layers, but is not limited thereto.

The electronic device 100 according to an embodiment may include a substantially opaque rear plate 111. In an embodiment, the rear plate 111 may form at least a portion of the second side 100B. In an embodiment, the rear plate 111 may be formed by coated or colored glass, ceramic, polymer, metal (e.g., aluminum, stainless steel (STS), or magnesium), or a combination of at least two of the materials.

The electronic device 100 according to an embodiment may include a side bezel structure (or a side member) 118 (e.g., a sidewall 141 of the frame structure 140 of FIG. 2). In an embodiment, the side bezel structure 118 may form at least a portion of the third side 100C of the electronic device 100 by being coupled to the front plate 102 and/or the rear plate 111. For example, the side bezel structure 118 may form the entire third side 100C of the electronic device 100, and for another example, the side bezel structure 118 may form the third side 100C of the electronic device 100 together with the front plate 102 and/or the rear plate 111.

Unlike the illustrated embodiment, in a case that the third side 100C of the electronic device 100 is partially formed by the front plate 102 and/or the rear plate 111, the front plate 102 and/or the rear plate 111 may include a region that is curved toward the rear plate 111 and/or the front plate 102 at a periphery thereof and extends seamlessly. The extending region of the front plate 102 and/or the rear plate 111 may be located, for example, at both ends of a long edge of the electronic device 100, but is not limited by the above-described example.

In an embodiment, the side bezel structure 118 may include metal and/or polymer. In an embodiment, the rear plate 111 and the side bezel structure 118 may be integrally formed and may include the same material (e.g., a metal material such as aluminum), but are not limited thereto. For example, the rear plate 111 and the side bezel structure 118 may be formed as separate configurations and/or may include different materials.

In an embodiment, the electronic device 100 may include at least one of a display 101, an audio module 103, 104, or 107, a sensor module (not illustrated), a camera module 105, 112, or 113, a key input device 117, a light emitting element (not illustrated), and/or a connector hole. In an embodiment, the electronic device 100 may omit at least one (e.g., the key input device 117 or the light emitting element (not illustrated)) of the components, or may additionally include another component.

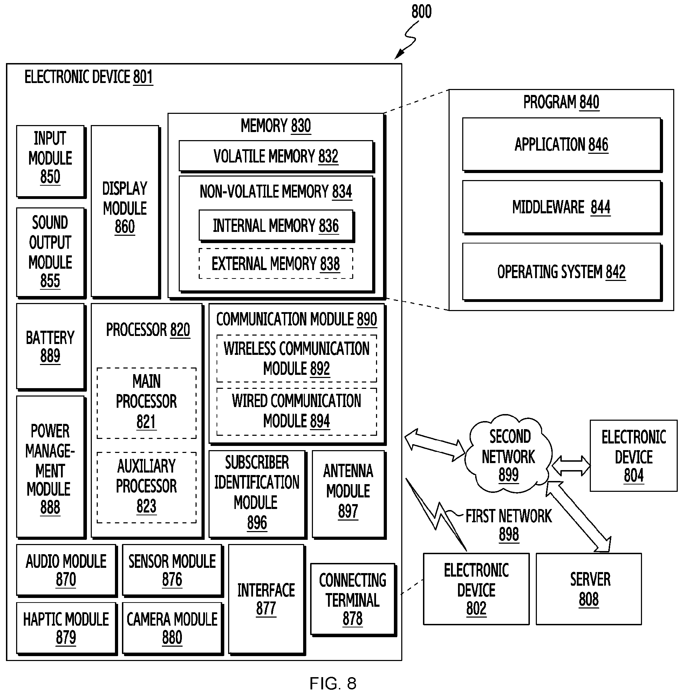

In an embodiment, the display 101 (e.g., a display module 860 of FIG. 8) may be visually exposed through a substantial portion of the front plate 102. For example, at least a portion of the display 101 may be visible through the front plate 102 forming the first side 100A. In an embodiment, the display 101 may be disposed on a back side of the front plate 102.

In an embodiment, an outer shape of the display 101 may be formed to be substantially the same as an outer shape of the front plate 102 adjacent to the display 101. In an embodiment, in order to expand an area in which the display 101 is visually exposed, a spacing between an outer periphery of the display 101 and an outer periphery of the front plate 102 may be formed to be substantially the same.

In an embodiment, the display 101 (or the first side 100A of the electronic device 100) may include a screen display region 101A. In an embodiment, the display 101 may provide a user with visual information through the screen display region 101A. In the illustrated embodiment, when the first side 100A is viewed from the front, the screen display region 101A is illustrated as being spaced apart from an outer periphery of the first side 100A and located inside the first side 100A, but is not limited thereto. In an embodiment, when the first side 100A is viewed from the front, at least a portion of a periphery of the screen display region 101A may substantially match a periphery of the first side 100A (or the front plate 102).

In an embodiment, the screen display region 101A may include a sensing region 101B configured to obtain biometric information of the user. Herein, a meaning of "the screen display region 101A including the sensing region 101B" may be understood to mean that at least a portion of the sensing region 101B may be overlapped with the screen display region 101A. For example, the sensing region 101B may mean a region capable of displaying visual information by the display 101 similarly to another region of the screen display region 101A, and additionally capable of obtaining biometric information (e.g., a fingerprint) of the user. In an embodiment, the sensing region 101B may be formed in the key input device 117.

In an embodiment, the display 101 may include a region in which a first camera module 105 (e.g., a camera module 880 of FIG. 8) is located. In an embodiment, an opening may be formed in the region of the display 101, and the first camera module 105 (e.g., a punch hole camera) may be at least partially disposed in the opening to face the first side 100A. In this case, the screen display region 101A may cover at least a portion of a periphery of the opening. In an embodiment, the first camera module 105 (e.g., an under display camera (UDC)) may be disposed below the display 101 to overlap the region of the display 101. In this case, the display 101 may provide the user with visual information through the region, and additionally, the first camera module 105 may obtain an image corresponding to a direction facing the first side 100A through the region of the display 101.

In an embodiment, the display 101 may be coupled with or disposed adjacent to touch sensing circuitry, a pressure sensor capable of measuring an intensity (pressure) of a touch, and/or a digitizer detecting an electromagnetic type stylus pen.

In an embodiment, the audio module 103, 104, or 107 (e.g., an audio module 870 of FIG. 8) may include microphone holes 103 and 104 and a speaker hole 107.

In an embodiment, the microphone holes 103 and 104 may include a first microphone hole 103 formed in a partial region of the third side 100C and a second microphone hole 104 formed in a partial region of the second side 100B. A microphone (not illustrated) for obtaining an external sound may be disposed inside the microphone holes 103 and 104. The microphone may include a plurality of microphones to sense a direction of sound.

In an embodiment, the second microphone hole 104 formed in a partial region of the second side 100B may be disposed adjacent to the camera module 105, 112, or 113. For example, the second microphone hole 104 may obtain sound according to an operation of the camera module 105, 112, and 113. However, it is not limited thereto.

In an embodiment, the speaker hole 107 may include an external speaker hole 107 and a call receiver hole (not illustrated). The external speaker hole 107 may be formed in a portion of the third side 100C of the electronic device 100. In an embodiment, the external speaker hole 107 may be implemented as one hole together with the microphone hole 103. Although not illustrated, the call receiver hole (not illustrated) may be formed in another portion of the third side 100C. For example, the call receiver hole may be formed on an opposite side of the external speaker hole 107 on the third side 100C. For example, with respect to the illustration of FIG. 1, the external speaker hole 107 may be formed on the third side 100C corresponding to a lower end portion of the electronic device 100, and the call receiver hole may be formed on the third side 100C corresponding to an upper end portion of the electronic device 100. However, it is not limited thereto, and in an embodiment, the call receiver hole may be formed at a location other than the third side 100C. For example, the call receiver hole may be formed by a spaced space between the front plate 102 (or the display 101) and the side bezel structure 118.

In an embodiment, the electronic device 100 may include at least one speaker (not illustrated) configured to output sound to an outside of the housing 110 through the external speaker hole 107 and/or the call receiver hole (not illustrated).

In an embodiment, a sensor module (not illustrated) (e.g., a sensor module 876 of FIG. 8) may generate an electrical signal or a data value corresponding to an operating state inside the electronic device 100 or an external environmental state. For example, the sensor module may include at least one of a proximity sensor, an HRM sensor, a fingerprint sensor, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

In an embodiment, the camera module 105, 112, and 113 (e.g., the camera module 880 of FIG. 8) may include the first camera module 105 disposed to face the first side 100A of the electronic device 100, a second camera module 112 disposed to face the second side 100B, and a flash 113.

In an embodiment, the second camera module 112 may include a plurality of cameras (e.g., a dual camera, a triple camera, or a quad camera). However, the second camera module 112 is not necessarily limited to including a plurality of cameras, and may include one camera.

In an embodiment, the first camera module 105 and the second camera module 112 may include one or a plurality of lenses, an image sensor, and/or an image signal processor.

In an embodiment, the flash 113 may include, for example, a light emitting diode or a xenon lamp. In an embodiment, two or more lenses (an infrared camera, a wide-angle lens, and a telephoto lens) and image sensors may be disposed on a side of the electronic device 100.

In an embodiment, the key input device 117 (e.g., an input module 850 of FIG. 8) may be disposed on the third side 100C of the electronic device 100. In an embodiment, the electronic device 100 may not include a portion or all of the key input device 117, and the key input device 117 not included may be implemented in another form, such as a soft key, on the display 101.

In an embodiment, the connector hole may be formed on the third side 100C of the electronic device 100 such that a connector of an external device may be accommodated. A connecting terminal (e.g., a connecting terminal 878 of FIG. 8) electrically connected to the connector of the external device may be disposed in the connector hole. The electronic device 100 according to an embodiment may include an interface module (e.g., an interface 877 of FIG. 8) for processing an electrical signal transmitted and received through the connecting terminal.

In an embodiment, the electronic device 100 may include the light emitting element (not illustrated). For example, the light emitting element (not illustrated) may be disposed on the first side 100A of the housing 110. The light emitting element (not illustrated) may provide state information of the electronic device 100 in an optical form. In an embodiment, the light emitting element (not illustrated) may provide a light source linked with an operation of the first camera module 105. For example, the light emitting element (not illustrated) may include an LED, an IR LED, and/or a xenon lamp.

FIG. 2 is an exploded perspective view of an electronic device according to an embodiment.

Hereinafter, redundant description of a configuration having the same reference numeral as the above-described configuration is omitted.

Referring to FIG. 2, an electronic device 100 according to an embodiment may include a frame structure 140, a first printed circuit board 150, a second printed circuit board 152, a cover plate 160, and a battery 170.

In an embodiment, the frame structure 140 may include a sidewall 141 forming an exterior (e.g., the third side 100C of FIG. 1) of the electronic device 100 and a support portion 143 extending inward from the sidewall 141. In an embodiment, the frame structure 140 may be disposed between a display 101 and a rear plate 111. In an embodiment, the sidewall 141 of the frame structure 140 may cover a space between the rear plate 111 and a front plate 102 (and/or the display 101), and the support portion 143 of the frame structure 140 may extend from the sidewall 141 in the space. According to an embodiment, the sidewall 141 forming a lateral side (e.g., the third side 100C of FIG. 1) of the electronic device 100 may include a speaker hole 107 connecting an inside and an outside of the electronic device 100. The speaker hole 107 may penetrate the sidewall 141.

In an embodiment, the frame structure 140 may support or accommodate other components included in the electronic device 100. For example, the display 101 may be disposed on a side of the frame structure 140 facing a direction (e.g., a +z direction), and the display 101 may be supported by the support portion 143 of the frame structure 140. For another example, the first printed circuit board 150, the second printed circuit board 152, the battery 170, and a second camera module 112 may be disposed on another side of the frame structure 140 facing an opposite direction (e.g., a -z direction) to the direction. Each of the first printed circuit board 150, the second printed circuit board 152, the battery 170, and the second camera module 112 may be seated in a recess defined by the sidewall 141 and/or the support portion 143 of the frame structure 140.

In an embodiment, each of the first printed circuit board 150, the second printed circuit board 152, and the battery 170 may be coupled with the frame structure 140. For example, the first printed circuit board 150 and the second printed circuit board 152 may be fixedly disposed in the frame structure 140 through a coupling member such as a screw. For example, the battery 170 may be fixedly disposed in the frame structure 140 through an adhesive member (e.g., a double-sided tape). However, it is not limited by the above-described example.

In an embodiment, the cover plate 160 may be disposed between the first printed circuit board 150 and the rear plate 111. In an embodiment, the cover plate 160 may be disposed on the first printed circuit board 150. For example, the cover plate 160 may be disposed on a side of the first printed circuit board 150 facing the -z direction.

In an embodiment, the cover plate 160 may at least partially overlap the first printed circuit board 150 with respect to a z-axis. In an embodiment, the cover plate 160 may cover at least a partial region of the first printed circuit board 150. Through this, the cover plate 160 may protect the first printed circuit board 150 from physical impact or prevent detachment of a connector coupled to the first printed circuit board 150.

In an embodiment, the cover plate 160 may be fixedly disposed on the first printed circuit board 150 through a coupling member (e.g., a screw), or may be coupled to the frame structure 140 together with the first printed circuit board 150 through the coupling member.

In an embodiment, the display 101 may be disposed between the frame structure 140 and the front plate 102. For example, the front plate 102 may be disposed on a side (e.g., the +z direction) of the display 101, and the frame structure 140 may be disposed on another side (e.g., the -z direction).

In an embodiment, the front plate 102 may be coupled with the display 101. For example, the front plate 102 and the display 101 may be adhered to each other through an optical adhesive member (e.g., an optically clear adhesive (OCA) or an optically clear resin (OCR)) interposed therebetween.

In an embodiment, the front plate 102 may be coupled with the frame structure 140. For example, the front plate 102 may include an outer portion extending outward the display 101 when viewed in a z-axis direction, and may be adhered to the frame structure 140 through an adhesive member (e.g., a double-sided tape) disposed between the outer portion of the front plate 102 and the frame structure 140 (e.g., the sidewall 141). However, it is not limited by the above-described example.

In an embodiment, a processor (e.g., a processor 820 of FIG. 8), memory (e.g., memory 830 of FIG. 8), and/or an interface (e.g., an interface 877 of FIG. 8) may be mounted on the first printed circuit board 150 and/or the second printed circuit board 152. The processor may include, for example, one or more of a central processing unit, an application processor, a graphics processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 100 to an external electronic device, and may include a USB connector, an SD card/MMC connector, or an audio connector. In an embodiment, the first printed circuit board 150 and the second printed circuit board 152 may be operatively or electrically connected to each other through a connection member (e.g., a flexible printed circuit board).

In an embodiment, the battery 170 (e.g., a battery 889 of FIG. 8) may supply power to at least one component of the electronic device 100. For example, the battery 170 may include a rechargeable secondary battery or a fuel cell. At least a portion of the battery 170 may be disposed on substantially the same plane as the first printed circuit board 150 and/or the second printed circuit board 152.

The electronic device 100 according to an embodiment may include an antenna module (not illustrated) (e.g., an antenna module 897 of FIG. 8). In an embodiment, the antenna module may be disposed between the rear plate 111 and the battery 170. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power with the external device.

In an embodiment, a housing 110 of the electronic device 100 may mean a configuration or a structure forming at least a portion of the exterior of the electronic device 100. In this regard, at least a portion of the front plate 102, the frame structure 140, and/or the rear plate 111 forming the exterior of the electronic device 100 may be referred to as the housing 110 of the electronic device 100.

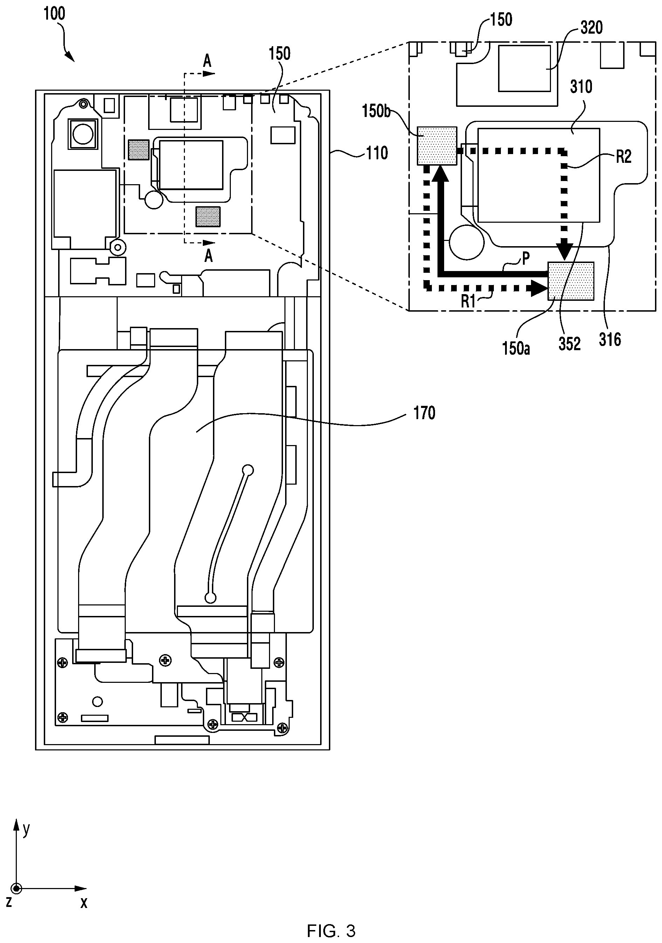

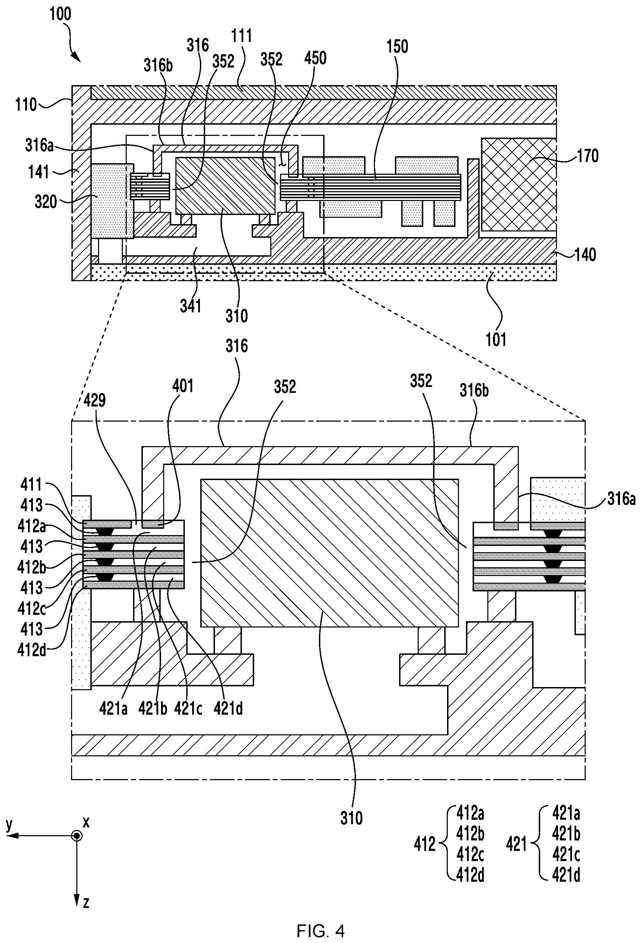

FIG. 3 is a diagram illustrating an interior of an exemplary electronic device. FIG. 4 is a cross-sectional view of an exemplary electronic device.

Referring to FIGS. 3 and 4, an electronic device 100 may include a printed circuit board 150, a speaker 310, a camera 320, and a battery 170 disposed on a frame structure 140 disposed in a housing 110. The electronic device 100 may at least partially refer to the electronic device 100 of FIG. 1 and the electronic device 100 of FIG. 2.

The electronic device 100 may include another printed circuit board (e.g., the second printed circuit board 152 of FIG. 2) spaced apart from the printed circuit board 150 (e.g., the first printed circuit board 150 of FIG. 2), and the another printed circuit board may be electrically connected to the printed circuit board 150 through a flexible printed circuit board. The printed circuit board 150 and the another printed circuit board may be disposed on both sides of the housing 110 of the electronic device 100, respectively. For example, the printed circuit board 150 may be disposed on a side (e.g., an upper end) (e.g., a +y-axis direction) of the housing 110 of the electronic device 100. The another printed circuit board may be disposed on another side (e.g., a lower end) (e.g., a -y-axis direction) of the housing 110 of the electronic device 100.

Electronic components (e.g., a camera, an optical sensor, a processor, or memory) disposed on the upper end of the electronic device 100 may be disposed on or connected to the printed circuit board 150. For example, at least one processor controlling the electronic components in the electronic device 100 may be disposed on the printed circuit board 150. The printed circuit board 150 may include an opening 352 (or an accommodating portion) for accommodating the speaker 310.

The opening 352 may reduce a thickness of the electronic device 100 by accommodating a portion of the speaker 310. For a thin thickness of the electronic device 100, the speaker 310 may not be disposed on the printed circuit board 150 and may be inserted into the opening 352 formed in the printed circuit board 150, and the speaker 310 may be supported by a frame structure (e.g., the frame structure 140 of FIG. 2). The speaker 310 may be disposed on the frame structure 140 through the opening 352 of the printed circuit board 150. For example, a portion of the speaker 310 may face an end portion of an acoustic duct 341 of the frame structure 140. A portion of the speaker 310 may protrude toward the frame structure 140 (or the acoustic duct 341) with respect to the printed circuit board 150, and another portion of the speaker 310 may protrude toward a rear plate 111 with respect to the printed circuit board 150. The speaker 310 may be inserted into the opening 352 formed at a location corresponding to the end portion of the acoustic duct 341 and may be supported by the frame structure 140. The opening 352 may be referred to as an accommodating portion in terms of a portion of the speaker 310 being accommodated. A side of the speaker 310 (e.g., a front side of the speaker 310) supported by the frame structure 140 may be a side of the speaker 310 on which a diaphragm generating an audio signal is disposed. In order to deliver the audio signal to the outside, the frame structure 140 may include the acoustic duct 341 connected to an audio hole formed on a lateral side of the electronic device 100. Another side of the speaker 310 opposite to the side of the speaker 310 may be a rear side of the speaker 310. The rear side of the speaker 310 may be a side on which a resonance space for reverberation of the audio signal is disposed. As the speaker 310 penetrates the opening 352 and contacts the frame structure 140, the electronic device 100 may be thinner than a case including the speaker 310 disposed on the printed circuit board 150.

The battery 170 may be disposed beside the printed circuit board 150 (in the -y-axis direction). The battery 170 may be spaced apart from the printed circuit board 150 and disposed at a lower portion of the electronic device 100. The battery 170 may be disposed at the lower portion of the electronic device 100, and may supply power to the printed circuit board 150 or an electronic component (e.g., the speaker 310, the camera 320, wireless communication circuitry, a power amplifier circuit, or at least one processor) 150b disposed on the printed circuit board 150 through power management integrated circuitry (PMIC). The battery 170 may be electrically connected to the power amplifier circuit of the wireless communication circuitry through conductive patterns in the printed circuit board 150. In order to transmit a radio frequency (RF) signal, the wireless communication circuitry may require a large amount of current or power. The conductive patterns in the printed circuit board 150 may transfer a large amount of current to the electronic components 150b disposed on the printed circuit board 150. For example, the current transferred through the printed circuit board 150 may be transferred along a current path P formed from the battery 170 to the electronic component (e.g., the processor or the power amplifier circuit) 150b.

Referring to FIG. 4, the printed circuit board 150 may include a plurality of non-conductive layers 421a, 421b, 421c, and 421d, a conductive pad 401, conductive patterns 411, and other conductive patterns 412a, 412b, 412c, and 412d.

The plurality of non-conductive layers 421a, 421b, 421c, and 421d may be formed of a polymer material and may include an insulating material. The plurality of non-conductive layers 421a, 421b, 421c, and 421d may provide one substrate or base material by being coupled with each other. The plurality of non-conductive layers 421a, 421b, 421c, and 421d formed of the insulating material may be disposed between the plurality of conductive patterns 411, 412a, 412b, 412c, and 412d. The plurality of non-conductive layers 421a, 421b, 421c, and 412d disposed between the plurality of conductive patterns 411, 412a, 412b, 412c, and 412d may separate the plurality of conductive patterns 411, 412a, 412b, 412c, and 412d.

The conductive pad 401 may be exposed to an outside of the printed circuit board 150. The conductive pad 401 may be disposed on an outer layer among outer layers among the plurality of non-conductive layers 421a, 421b, 421c, and 421d. For example, the conductive pad 401 may be disposed on a first non-conductive layer 421a forming an upper layer of the printed circuit board 150. For example, the first non-conductive layer 421a may correspond to a non-conductive layer closest to the rear side of the speaker 310 among the plurality of non-conductive layers 421a, 421b, 421c, and 421d.

The conductive pad 401 may be coupled with a shield can or a case 316 for providing a resonance space 450 of the speaker 310. For example, the case 316 may be disposed on the rear side of the speaker 310, and may provide the resonance space 450 for audio emitted from the speaker 310. The case 316 may include a sidewall 316a and a plate 316b disposed on the sidewall 316a. The sidewall 316a of the case 316 may be disposed on the printed circuit board 150. For example, the sidewall 316a of the case 316 may be disposed along the opening 352 of the printed circuit board 150 when a printed circuit board is viewed in a -z-axis direction. The case 316 may surround the rear side of the speaker 310 and a portion of a lateral side of the speaker 310. The case 316 may be formed of a conductive material. The case 316 may be welded or bonded to a conductive pad. The case 316 may shield external noise or magnetic fields by being formed of the conductive material, but it may be difficult to block an influence caused by current flowing along a surface of the case 316. In terms of shielding external signals, the case 316 may be referred to as a shield can, and in terms of surrounding a speaker, it may be referred to as an enclosure or a housing. The case 316 may surround the rear side of the speaker 310 to provide the resonance space 450 of the speaker 310. The resonance space 450 may be configured to emphasize a low-frequency band of an audio signal emitted from the speaker. The case 316 may generate an audio signal in the low-frequency band by providing the resonance space 450. The case 316 may be coupled to the conductive pad 401. The case 316 disposed on the conductive pad 401 may be sealed with the printed circuit board 150. As a gap between the case 316 and the printed circuit board 150 is sealed, the case 316 may reduce an audio signal generated from the speaker 310 from being delivered to the outside. For example, the case 316 sealed while surrounding an outside of the speaker 310 may reduce sound leakage to an outside of the case 316.

The printed circuit board 150 may include the conductive patterns 411 disposed on the first non-conductive layer 421a among the non-conductive layers 421a, 421b, 421c, and 421d and the other conductive patterns 412a, 412b, 412c, and 412d disposed between the non-conductive layers 421a, 421b, 421c, and 421d. The first non-conductive layer 421a may be a non-conductive layer contacting the case 316. The conductive pattern 412a may be disposed on the non-conductive layer 421b. The conductive pattern 412b may be disposed on the non-conductive layer 421c. The conductive pattern 412c may be disposed in the -z-axis direction of the non-conductive layer 421d. The conductive pattern 412d may be disposed in a z-axis direction of the non-conductive layer 421d.

The conductive patterns 411 disposed on the first non-conductive layer 421a may be spaced apart from the conductive pad 401. For example, the conductive patterns 411 and the conductive pad 401 may be electrically disconnected from each other. An isolation portion 429 may be located between the conductive patterns 411 and the conductive pad 401. The isolation portion 429 may be filled with a non-conductive material or may be formed as an empty space. For example, the isolation portion 429 may be formed of the same material as a material of the non-conductive layers 421a, 421b, 421c, and 421d. The isolation portion 429 may be integrally formed with the first non-conductive layer 421a. For example, the isolation portion 429 between the conductive patterns 411 and the conductive pad 401 may be a protruding portion of the first non-conductive layer 421a. Although the isolation portion 429 has been described as filling a space between the conductive patterns 411 and the conductive pad 401 from the first non-conductive layer 421a, it is not limited thereto and may be formed as an empty space.

The conductive patterns 411 and the other conductive patterns 412a, 412b, 412c, and 412d may include a conductive line transferring a signal or power and/or a ground line connected to a ground portion (e.g., a conductive portion of the frame structure 140) of the electronic device 100. The conductive patterns 411 may be disposed on the same layer (e.g., the first non-conductive layer 421a) as the conductive pad 401. The conductive patterns 411 may be spaced apart from another conductive pad 401 and electrically separated from it. The other conductive patterns 412a, 412b, 412c, and 412d may be electrically separated from the conductive pad 401 by being disposed on the other layers 421b, 421c, and 421d on which the conductive pad 401 is disposed. The conductive patterns 411 and the other conductive patterns 412a, 412b, 412c, and 412d may be electrically connected to each other. For example, the conductive patterns 411 and the other conductive patterns 412a, 412b, 412c, and 412d may be connected to each other through a conductive via 413.

The conductive pad 401 may be electrically disconnected from the ground line and/or the ground portion by being electrically separated from the conductive patterns 411 and the other conductive patterns 412a, 412b, 412c, and 412d. The case 316 may be connected to the conductive pad 401 electrically disconnected from the ground line or the ground portion. As the case 316 is separated from the conductive patterns 411 and the other conductive patterns 412a, 412b, 412c, and 412d, current flowing to the case 316 may be limited. As the current flowing to the case 316 is removed or reduced, an influence caused by the current on the speaker 310 disposed below the case 316 may be reduced.

Referring to FIG. 3 again, the current flowing along the case 316 may generate a magnetic field. The generated magnetic field may induce a current in a coil in the speaker 310. Due to the induced current, the audio signal of the speaker 310 may include noise. As the case 316 and the conductive pad 401 are separated from the conductive patterns 411 and other conductive patterns 412, the current transferred to the case 316 may be blocked or limited, thereby reducing the magnetic field around the speaker 310. Due to the reduction of the magnetic field, noise transferred to the speaker 310 may be decreased. The magnetic field transferred to the speaker 310 may be proportional to an intensity or magnitude of current and may be inversely proportional to a square of a distance between the speaker 310 and a current path. As current is induced to conductive patterns at an outer periphery of the case 316 instead of the case 316, the distance between the speaker 310 and the current path may be increased. As the current path is provided as a first electrical path R1 instead of a second electrical path R2, the magnetic field around the speaker 310 may be reduced. In the printed circuit board 150, current may flow through a portion of conductive patterns operating as the ground line. For example, in a case that the case (e.g., the case 316 of FIG. 4) including a conductive material is electrically connected to the ground line or the ground portion, the current may flow along the second electrical path R2 among the electrical paths R1 and R2 along a surface of the case. The currents may form a magnetic field affecting electronic components. The magnetic field caused by the currents may induce a current in a coil of an electronic component including the coil therein, such as a camera or a speaker. Due to the induced current, the speaker may generate an audio signal having noise. In order to reduce or remove the noise, the printed circuit board 150 and the case 316 for the speaker 310 may be configured to limit current flowing around the speaker 310 from flowing through the case 316. In a case that the case 316 is electrically separated from the ground line or the ground portion, current flowing from the electronic component 150b disposed around the speaker 310 to the battery 170 or power management circuitry 150a may be limited (or reduced) from flowing to the surface of the case 316. For example, the conductive pad 401 connected to the case 316 may be electrically disconnected from the conductive patterns 411, 412a, 412b, 412c, and 412d operating as the ground line. The ground line electrically disconnected from the case 316 may limit current from flowing along the second electrical path R2 formed along the surface of the case 316 and may be configured such that current flows along the first electrical path R1.

As the case 316 is electrically separated from conductive patterns connected to the ground portion, noise transferred to the speaker 310 may be reduced. However, it is not limited thereto, and according to an embodiment, the conductive pad 401 may be selectively connected to the conductive pattern 411 through a switch.

Although the conductive pad 401 has been described as being electrically separated from the other conductive patterns 412a, 412b, 412c, and 412d stacked on layers other than the first non-conductive layer 421a, it is not limited thereto. For example, the conductive pad 401 may be connected through a conductive via to a conductive pattern or a conductive portion disposed on the other non-conductive layers 421a, 421b, 421c, and 421d. In order to secure rigidity of the conductive pad 401 and secure rigidity of the case 316 coupled to the conductive pad 401, the conductive pad 401 may be coupled to the conductive portion disposed on the other non-conductive layers 421a, 421b, 421c, and 421d. In order to reinforce the rigidity of the conductive pad 401, a portion of the conductive pad 401 may be plated. For example, a lateral side of the conductive pad 401 may be plated.

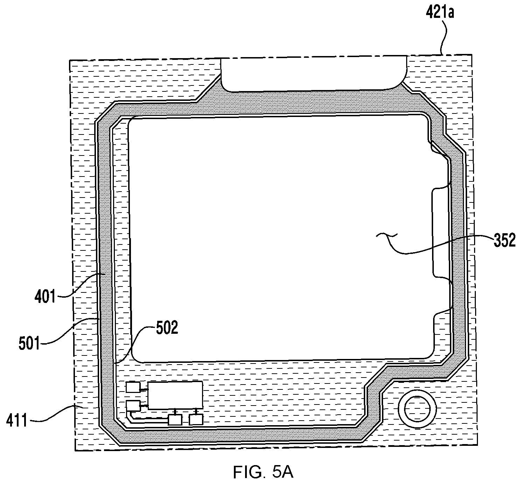

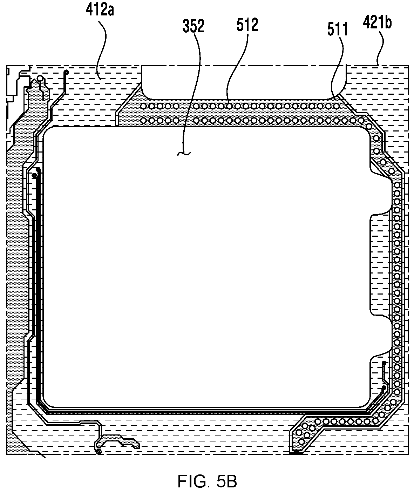

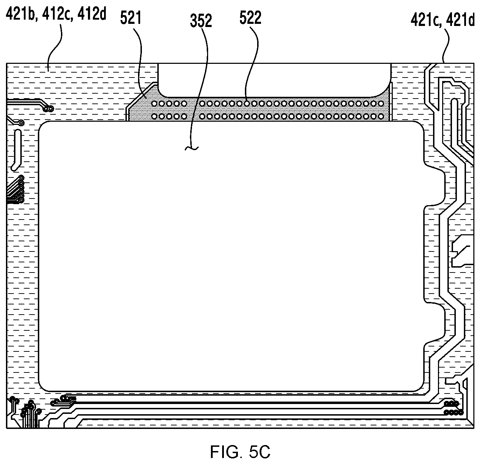

A structure of the conductive portion in the printed circuit board 150 for securing the rigidity of the conductive pad 401 is described through FIGS. 5A, 5B, and 5C.

FIGS. 5A, 5B, and 5C are exemplary diagrams illustrating a periphery of an opening portion on which a speaker of each of layers of a printed circuit board is mounted.

Referring to FIG. 5A, a conductive pad 401 and conductive patterns 411 may be disposed on a first non-conductive layer 421a. The conductive pad 401 may be disposed along a periphery of an opening 352 of a printed circuit board 150. The conductive patterns 411 may be conductive patterns disposed beside the conductive pad 401 disposed on the first non-conductive layer 421a.

The conductive pad 401 and the conductive patterns 411 may be spaced apart from each other. In order for the conductive pad 401 and the conductive patterns 411 to be electrically separated from each other, the first non-conductive layer 421a of the printed circuit board 150 may include a first insulation portion 501 and a second insulation portion 502.

Although the conductive pad 401 is represented as forming a closed curve, it is not limited thereto, and the conductive pad 401 may be configured to be separated from each other to be disposed in portions coupled with a connection portion (e.g., a leg) of a case (e.g., the case 316 of FIG. 4). The conductive patterns 411 may be electrically connected to a ground portion of an electronic device. Through the first insulation portion 501, the conductive patterns 411 may be electrically separated from the conductive pad 401. The case 316 electrically connected to the conductive pad 401 separated from the conductive patterns 411 may be electrically separated from a ground. The case 316 separated from the conductive patterns 411 may prevent current transferred through the conductive patterns 411 from flowing into the case 316.

According to an embodiment, the first insulation portion 501 and the second insulation portion 502 may be a portion of the first non-conductive layer 421a. The first insulation portion 501 may be a portion of the first non-conductive layer 421a disposed between the conductive pad 401 and the conductive patterns 411. The second insulation portion 502 may be a portion of the first non-conductive layer 421a disposed between the conductive pad 401 and a conductive portion around the opening portion 352 surrounded by the conductive pad 401.

According to an embodiment, the conductive pad 401 may be connected to the conductive patterns 411 connected to the ground through a capacitor. A direct current transferred through the conductive patterns 411 may not be transferred to the conductive pad 401 by the capacitor. An alternating current having a frequency may, when necessary, be transferred to the conductive pad in a predetermined frequency band through the conductive patterns 411.

Referring to FIG. 5B, a first reinforcement pattern 511 and first other conductive patterns 412a among other conductive patterns may be disposed on a second non-conductive layer 421b. The first reinforcement pattern 511 may be disposed along a portion of the periphery of the opening 352 of the printed circuit board 150. The first other conductive patterns 412a may be conductive patterns disposed beside the first reinforcement pattern 511 disposed on the second non-conductive layer 421b.

The first reinforcement pattern 511 and the first other conductive patterns 412a may be spaced apart from each other. The first reinforcement pattern 511 may be electrically connected to a conductive pad (e.g., the conductive pad 401 of FIG. 5A). For example, the first reinforcement pattern 511 may be connected through a conductive via 512 connected to the conductive pad 401. The conductive pad 401 may secure rigidity by being coupled to the first reinforcement pattern 511 through the conductive via 512. The conductive pad 401 coupled to the conductive via 512 and the first reinforcement pattern 511 may secure rigidity for maintaining coupling with the case (e.g., the case 316 of FIG. 4) based on the increased rigidity. The first reinforcement pattern 511 may be referred to as a conductive pattern or a conductive portion in terms of including a conductive material.

The first reinforcement pattern 511 may be separated from the other conductive patterns (e.g., the first other conductive patterns 412a), and even when the case 316 is connected to the first reinforcement pattern 511 through the conductive via 512 and the conductive pad 401, separation from the ground may be maintained.

Referring to FIG. 5C, a second reinforcement pattern 521 and remaining conductive patterns 412b, 412c, and 412d except for the first other conductive patterns 412a among the other conductive patterns may be disposed on remaining non-conductive layers 421c and 421d. The second reinforcement pattern 521 may be spaced apart from remaining conductive patterns 421b, 421c, and 421d. Similar to the first reinforcement pattern 511 of FIG. 5B, the second reinforcement pattern 521 may be electrically connected to the first reinforcement pattern 511 and the conductive pad 401 through a conductive via 522. The conductive via 522 may be formed at a location corresponding to a location of the conductive via 512 of FIG. 5B. The second reinforcement pattern 521 may be disposed below the first reinforcement pattern 511 and may be formed to be narrower than the first reinforcement pattern 511.

The first reinforcement pattern 511 and the second reinforcement pattern 521 may be disposed in a portion having weak rigidity around the opening 352 of the printed circuit board 150. Through the reinforcement patterns 511 and 521 reinforcing rigidity of the printed circuit board 150, the case 316 may be stably coupled to the conductive pad 401.

The second reinforcement pattern 521 may be separated from the other conductive patterns, and even when the case 316 is connected to the second reinforcement pattern 521 through the conductive via 512, the conductive pad 401, the first reinforcement pattern 511, and the conductive via 522, separation from the ground may be maintained. The reinforcement patterns 511 and 521 may be disposed on each of a plurality of layers configuring the printed circuit board 150.

In order to prevent the case 316 from being detached from the conductive pad 401, the conductive patterns 412a, 412b, 412c, and 412d disposed on the non-conductive layer 421b, 421c, or 421d different from the non-conductive layer 421a on which the conductive pad 401 is disposed may reinforce rigidity of the conductive pad 401 through the conductive via 512. The conductive patterns 412a, 412b, 412c, and 412d disposed on the non-conductive layer 421b, 421c, or 421d different from the non-conductive layer 421a on which the conductive pad 401 is disposed may reinforce rigidity of the conductive pad 401 by extending wider than a width of the conductive pad 401.

The reinforcement pattern 511 or 521 of FIGS. 5B and 5C may be omitted. The reinforcement pattern of FIGS. 5B and 5C may be excluded, and a portion on which the reinforcement pattern is disposed may be filled by the non-conductive layers 421a, 421b, 421c, and 421d. The portion filled by the non-conductive layers 421a, 421b, 421c, and 421d may be a fill-cut portion formed entirely of the non-conductive layers 421a, 421b, 421c, and 421d except for a portion of the conductive pad (e.g., the conductive pad 401 of FIG. 5A). The conductive pad 401 may be electrically separated from the conductive patterns by including the fill-cut portion. As a flow of a return current of the conductive pad 401 is removed, current affecting a speaker 310 may be reduced.

The fill-cut portion may be a neck portion having a narrow width of the printed circuit board 150 between the speaker 310 and a camera 320.

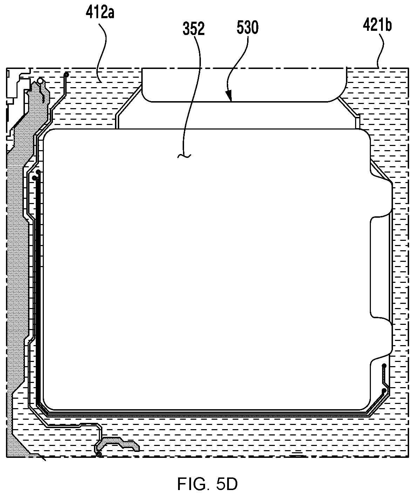

FIG. 5D is an exemplary diagram illustrating a layer from which a conductive portion of the printed circuit board is partially removed.

Referring to FIGS. 4 and 5D, the conductive patterns 412a, 412b, 412c, and 412d disposed on the non-conductive layers 421b, 421c, and 421d except for the first non-conductive layer 421a contacting the case 316 among the non-conductive layers 421a, 421b, 421c, and 412d of the printed circuit board 150 may be removed in a partial region 530. For example, the partial region 530 may be referred to as a fill-cut portion or a fill-cut region when considering the portion from which the conductive patterns 412a, 412b, 412c, and 412d are removed. The partial region 530 may be referred to as a neck portion in terms of being a relatively narrow portion of the printed circuit board 150 or the non-conductive layer 421a.

The partial region 530, which is the fill-cut portion or the fill-cut region, may be a narrow-width portion among a portion around the opening 352 for the speaker. For example, a side of the partial region 530 may be formed to face the speaker, and another side thereof to face another electronic component. The conductive patterns 412a, 412b, 412c, and 412d may be at least partially removed in the partial region 530. For example, in the partial region 530 of a second layer 421b disposed below a first layer 421a of the printed circuit board 150, the conductive patterns 412a (e.g., a ground line or a signal line) may be removed. In the partial region 530 of the non-conductive layers 421b, 421c, and 421d except for the first non-conductive layer 421a contacting the case 316 among the layers 421a, 421b, 421c, and 421d of the printed circuit board 150, the conductive patterns 412b, 412c, and 412d may be removed. The partial region 530 may not include a conductive portion except for the first non-conductive layer 421a on which the conductive pad 501 is exposed.

Referring to FIGS. 5A, 5B, 5C, and 5D, the conductive patterns 412a, 412b, 412c, and 412d may be electrically separated from the conductive pad 501. On the first non-conductive layer 421a, the conductive pad 501 is electrically separated from the conductive pad 411, and the conductive patterns 412a, 412b, 412c, and 412d disposed except for the partial region 530 of the second non-conductive layer 421b, the third non-conductive layer 421c, and the fourth non-conductive layer 421d may be electrically separated from the conductive pad 501. The conductive patterns 412a, 412b, 412c, and 412d may be electrically disconnected from each other in the partial region 530. As the conductive patterns 412a, 412b, 412c, and 412d are removed in the partial region 530, current flowing in the printed circuit board 150 may flow while bypassing the partial region 530, and an influence of the current on the speaker 310 may be reduced.

**[Table 1]**

| Mode | Points at which a magnetic field intensity is equal to or less than a reference magnetic field intensity on a printed circuit board in which a pad and a conductive pattern are connected. | Points at which a magnetic field intensity is equal to or less than a reference magnetic field on a printed circuit board in which a pad and a conductive pattern are separated. |
|---|---|---|
| LTE B41 | 221 | 391 |
| NR n78 | 286 | 476 |
| WIFI 2.4G 11b | 131 | 348 |

Referring to Table 1, the number of points at which an intensity of a magnetic field generated by a current flow of the printed circuit board on which the speaker is mounted is equal to or less than a reference intensity (e.g., -38 dB A/m) while the electronic device operates according to each communication mode (or communication protocol) is illustrated.

In the printed circuit board in which the conductive pad and the conductive pattern are separated, the number of points at which a magnetic field intensity is equal to or less than a threshold magnetic field intensity may be greater than the number of points at which a magnetic field intensity is equal to or less than the threshold magnetic field intensity in the printed circuit board in which the conductive pad and the conductive pattern are connected. As the conductive pad is separated from the conductive pattern, current flowing to the case through the conductive pad is limited, and a point at which an intensity of a magnetic field caused by the current is equal to or less than the reference intensity may increase. As the magnetic field around the speaker becomes weak, noise of the speaker may be improved.

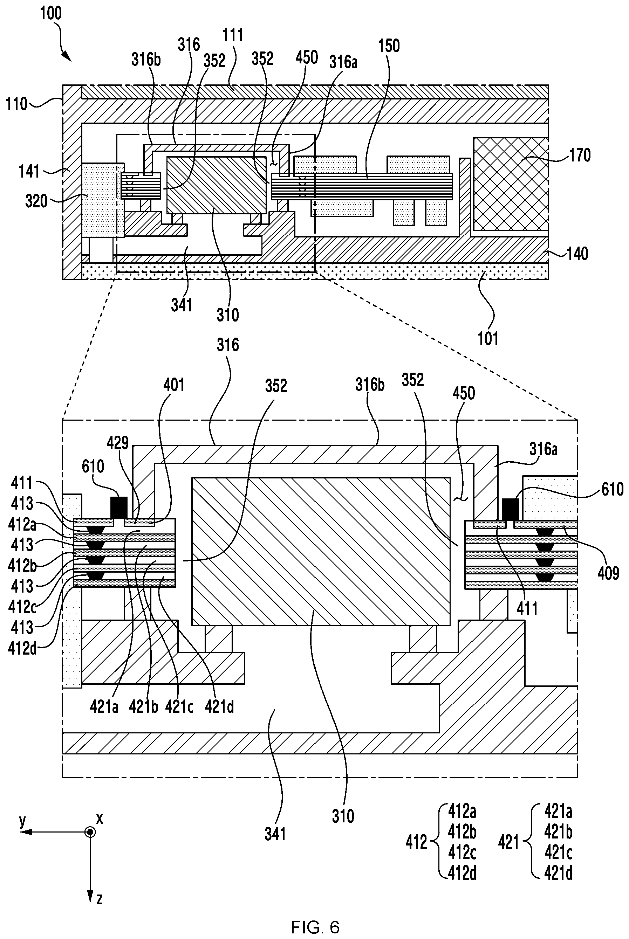

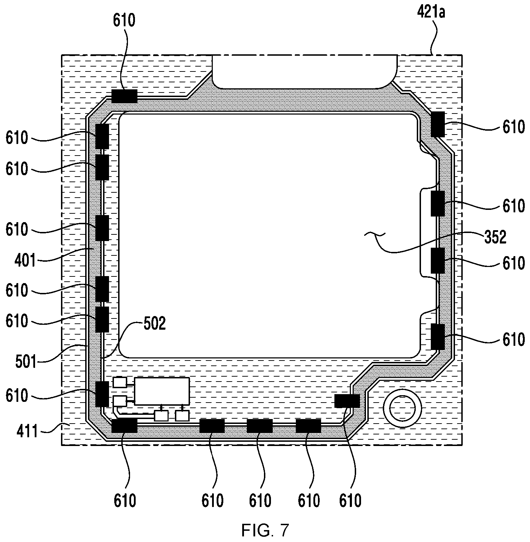

FIG. 6 is a cross-sectional view of an exemplary electronic device including a capacitor connecting a conductive pad and conductive patterns. FIG. 7 is an exemplary diagram illustrating a periphery of an opening portion of a printed circuit board including a capacitor connecting a conductive pad and conductive patterns.

Referring to FIGS. 6 and 7, an electronic device 100 may include a printed circuit board 150, a speaker 310, a camera 320, and a battery 170 disposed on a frame structure 140 disposed in a housing 110. The electronic device 100 may at least partially refer to the electronic device 100 of FIG. 1, the electronic device 100 of FIG. 2, the electronic device 100 of FIG. 3, and the electronic device 100 of FIG. 4. The printed circuit board 150 may include a plurality of non-conductive layers 421a, 421b, 421c, and 421d, a conductive pad 401, conductive patterns 411, and other conductive patterns 412a, 412b, 412c, and 412d. The printed circuit board 150 may refer to at least a portion of the printed circuit board 150 of FIGS. 4, 5A, 5B, 5C, and 5D.

The housing 110, the printed circuit board 150, the speaker 310, the camera 320, the battery 170, the plurality of non-conductive layers 421a, 421b, 421c, and 421d, the conductive pad 401, the conductive patterns 411, and the other conductive patterns 412a, 412b, 412c, and 412d disposed on the frame structure 140 disposed in the housing 110 may be substantially the same as or similar to the housing 110, the printed circuit board 150, the speaker 310, the camera 320, the battery 170, the plurality of non-conductive layers 421a, 421b, 421c, and 421d, the conductive pad 401, the conductive patterns 411, and the other conductive patterns 412a, 412b, 412c, and 412d of FIGS. 1, 2, 3, 4, 5A, 5B, 5C, and 5D. Description of a redundant portion is omitted.

According to an embodiment, the conductive pad 401 may be isolated from the conductive patterns 411, 412a, 412b, 412c, and 412d operating as a ground of the printed circuit board 150. The conductive pad 401 isolated from the conductive patterns 411, 412a, 412b, 412c, and 412d may reduce an influence of a magnetic field on the speaker 310 caused by a return current flowing along the conductive patterns 411, 412a, 412b, 412c, and 412d of the printed circuit board 150. As the influence of the magnetic field is reduced, unnecessary current flowing in a coil of the speaker 310 may be reduced, and noise of the speaker 310 may be reduced. The return current may indicate that current supplied from a power source (e.g., the battery 170 or power management circuitry 150a) to a load (e.g., hardware elements such as an electronic component 150b) is transferred through a ground portion.

According to an embodiment, the conductive pad 401 disposed on the printed circuit board 150 may be connected to one conductive pattern (e.g., the conductive pattern 411 disposed on the first non-conductive layer 421a) among the conductive patterns 411, 412a, 412b, 412c, and 412d through at least one element 610.

Referring to FIG. 7, the at least one element 610 may be disposed to contact the conductive pad 401 disposed along an opening portion 352. The at least one element 610 may be disposed along the conductive pad 401 formed in a closed curve. The conductive pad 401 may be electrically separated from the conductive pattern 411 on the first non-conductive layer 421a through a first insulation portion 501 and a second insulation portion 502. The at least one element 610 may connect the conductive pad 401 and the conductive pattern 411 by being disposed across the first insulation portion 501 or the second insulation portion 502.

According to an embodiment, the at least one element 610 may include a capacitor. An end of the elements 610 may be connected to the conductive pad 401, and another end of the at least one element 610 may be connected to the conductive pattern 411. The at least one element 610, which is a capacitor, may limit (or reduce) a return current from flowing to a case 316 through the conductive pad 401. For example, the elements 610, which are capacitors, may limit (or reduce) current flowing from an electronic component (e.g., the electronic component 150b of FIG. 4) on a PCB (e.g., the PCB 150 of FIG. 4) to the rechargeable battery 170 (or the power management circuitry 150a) through the case 316. The at least one element 610, which is a capacitor, may operate as being open between the conductive pad 401 and the conductive patterns 411, 412a, 412b, 412c, and 412d with respect to a low frequency or direct current. For example, the conductive pad may operate as if electrically disconnected from the conductive patterns 411, 412a, 412b, 412c, and 412d in a first frequency band by the at least one element 610, and may operate as if electrically connected to the conductive patterns 411, 412a, 412b, 412c, and 412d in a second frequency band higher than the first frequency band. The at least one element 610, which is a capacitor, may improve performance of an antenna disposed around the speaker 310, as the conductive pad 401 and the case 316 and the conductive patterns 411, 412a, 412b, 412c, and 412d, which operate as a ground, are electrically connected with respect to a radio frequency (RF) signal, which is a high-frequency signal. For example, the at least one element 610, which is a capacitor, may be configured such that, while the electronic device 100 transmits a signal to an external electronic device (e.g., an electronic device 804 of FIG. 8), the case 316 operates as a ground together with the conductive pad 401 and the conductive patterns 411, 412a, 412b, 412c, and 412d. For example, the electronic device 100 may further include wireless communication circuitry and an antenna. The wireless communication circuitry may be disposed on the printed circuit board 150 and may receive current from a battery (e.g., the battery 170 of FIG. 4) through the printed circuit board 150 and power management circuitry or a power amplifier circuit disposed on the printed circuit board 150. For example, the wireless communication circuitry and the power amplifier circuit may be electrically connected to the battery through the conductive patterns 411, 412a, 412b, 412c, and 412d in the printed circuit board 150. The antenna may be electrically connected to the wireless communication circuitry and may be disposed between the printed circuit board 150 and a sidewall of the housing 110. The antenna may face the sidewall of the housing 110.

The at least one element 610 may reduce noise of the speaker 310 by reducing generation of an induced current in a coil of the speaker 310 by limiting a return current from flowing around the speaker 310 or to the case 316 surrounding the speaker 310, and at the same time, improve performance of an antenna by causing conductive portions (e.g., the conductive pad 401 and the case 316) to have the same potential as a ground with respect to a high-frequency signal.

According to the above-described embodiment, a magnetic field according to a current flow of the printed circuit board 150 separated from the conductive patterns operating as a ground and the conductive pad 401 may be reduced.

The electronic device according to the above-described embodiment may improve noise generated in a speaker or a receiver. As current flowing around the speaker or the receiver is reduced, magnitude of a magnetic field around the speaker or the receiver may be reduced or removed. As noise generated by the magnetic field is reduced, acoustic quality of the speaker or the receiver may be improved.

The technical problems to be achieved in this document are not limited to those described above, and other technical problems not mentioned herein will be clearly understood by those having ordinary knowledge in the art to which the document belongs.

An electronic device (e.g., the electronic device 100 of FIG. 4) according to the above-described embodiment may include a rechargeable battery 170 (e.g., the battery 170 of FIG. 3) and a housing 110. The electronic device may include a speaker (e.g., the speaker 310 of FIG. 4) in the housing. The electronic device 100 may include a printed circuit board (PCB) (e.g., the printed circuit board 150 of FIG. 4) including an opening portion (e.g., the opening portion 352 of FIG. 4) accommodating the speaker 310. The electronic device 100 may include a case (e.g., the case 316 of FIG. 4) surrounding a rear side of the speaker and disposed on the PCB. The PCB 150 may include a conductive pad (e.g., the conductive pad 401 of FIG. 4) disposed along a peripheral portion of the opening portion and coupled to the case, and conductive patterns (e.g., the conductive patterns 411 of FIG. 4) spaced apart from the conductive pad and disposed on a layer of the PCB on which the conductive pad is disposed. The electronic device may include a capacitor (e.g., the at least one element 610 of FIG. 6) disposed on the PCB 150. The capacitor may be configured to reduce current flowing from the component on the PCB to the rechargeable battery through the case and to cause the case to operate as a ground while the electronic device transmits a signal to an external electronic device. The capacitor may connect the conductive patterns and the conductive pad.

The conductive pad may be connected, through the capacitor (e.g., the at least one element 610 of FIG. 6), to the conductive patterns 411 electrically connected to a ground portion of the electronic device 100. By the at least one element, the conductive pad may be electrically disconnected from the conductive patterns 411 in a first frequency band and electrically connected to the conductive patterns 411 in a second frequency band higher than the first frequency band.

According to the above-described embodiment, the conductive patterns may limit a return current flowing through the conductive pattern from being transferred to a shield can through the conductive pad by being separated from the conductive pad. As the current flowing in the shield can is limited, current flowing around the speaker may be reduced. According to the reduction of the current flowing around the speaker, magnitude of a magnetic field formed around the speaker may be decreased, or the magnetic field may be removed. As noise caused by the magnetic field is reduced, quality of an audio signal of the speaker may be improved.

According to an embodiment, the speaker may be configured to provide an audio signal to an outside of the electronic device through an acoustic duct located in front of the speaker. The case may provide a resonance space (e.g., the resonance space 450 of FIG. 4) for the audio signal.

The electronic device according to the above-described embodiment may improve quality of an audio signal in a low frequency band of the speaker by including the resonance space. The case may prevent sound leakage of an audio signal emitted from the speaker as a space between the case and the printed circuit board is sealed. According to the prevention of the sound leakage, magnitude of the audio signal may be maintained, and quality of the audio signal may be improved.

According to an embodiment, the PCB may include a plurality of non-conductive layers (e.g., non-conductive layers 421a, 421b, 421c, and 421d) forming the substrate, and other conductive patterns (e.g., the other conductive patterns 412a, 412b, 412c, and 412d of FIG. 4) disposed on respective ones of the plurality of non-conductive layers.

The PCB according to the above-described embodiment may provide a ground or a ground portion of the electronic device and may provide a line for transmitting power or a signal by including the other conductive patterns. For example, the conductive patterns may connect electronic components mounted on the printed circuit board to each other and may deliver power delivered from the battery to the electronic component.

According to an embodiment, the conductive pad may be disposed on a non-conductive layer, among the plurality of non-conductive layers, close to the rear side of the speaker.

The conductive pad according to the above-described embodiment may be disposed to be exposed to an outer side of the printed circuit board for bonding with a shield can or a case for providing a resonance space.

According to an embodiment, the other conductive patterns may be disposed on respective ones of remaining non-conductive layers, among the plurality of non-conductive layers, other than the non-conductive layer close to the rear side of the speaker.

According to the above-described embodiment, the conductive patterns may be electrically disconnected from the conductive pattern by being disposed on another layer. By being separated from each other, the conductive patterns and the conductive pad may block current from flowing to the case, and generation of a magnetic field around the speaker may be reduced by the blocking of the current. The speaker may reduce noise as an induced current of a coil generated by the magnetic field is reduced.

According to an embodiment, the other conductive patterns may be connected through a conductive via penetrating the plurality of non-conductive layers and may be electrically disconnected from the conductive pad.

According to an embodiment, the conductive patterns may be coupled to each other through the conductive via. A plurality of ground portions connected to the conductive patterns through the conductive via may provide a wide ground.

According to an embodiment, the electronic device may further include a camera connected to the PCB. The speaker 310, which is a receiver delivering an audio signal received through communication with an external electronic device 100, may be disposed at a location adjacent to the camera.

According to an embodiment, a portion of a lateral side of the conductive pad may be surrounded by a conductive thin film.

According to an embodiment, the PCB may include reinforcement patterns (e.g., the first reinforcement pattern 511 of FIG. 5B and the second reinforcement pattern 512 of FIG. 5C) connected to the conductive pad through a conductive via and disposed in the PCB.

According to an embodiment, each of the conductive portions may be spaced apart from the conductive patterns.

According to the above-described embodiment, the pad may secure rigidity by being connected to the conductive portions. The conductive pad securing rigidity may maintain bonding force with the case. The conductive pad maintaining coupling with the case may prevent a return current from being transferred to the case through the conductive pad by being spaced apart from the conductive patterns. The limited current or the reduced current may decrease magnitude of a magnetic field around the speaker. Through the decreased magnetic field, an amount of an induced current in the speaker may be reduced, and audio quality of the speaker may be improved by the reduced induced current.

According to an embodiment, the electronic device may further include at least one processor disposed on the PCB 150 and operatively connected to the speaker 310.

According to an embodiment, the speaker may be disposed on a support portion in the housing, the support portion including an acoustic duct connected to an audio hole formed in the housing.

According to the above-described embodiment, an audio signal may be delivered to the outside of the electronic device through the acoustic duct connected to the audio hole.

According to an embodiment, the case may limit generation of a magnetic field caused by a current flowing along the case by being electrically disconnected from the conductive patterns.

According to an embodiment, the electronic device may further include a switch configured to selectively connect the conductive pad and a portion of the conductive patterns.

According to an embodiment, the electronic device may further include wireless communication circuitry. The electronic device may further include a battery (e.g., the battery 170 of FIG. 4). The battery may be disposed in the housing.

The battery may be electrically connected through the conductive patterns in the PCB 150. The battery may be electrically connected to a power amplifier circuit of the wireless communication circuitry.

The battery may be electrically connected to a power amplifier circuit of the wireless communication circuitry through the conductive pattern in the PCB.

The printed circuit board according to the above-described embodiment may be connected to the wireless communication circuitry, and the power amplifier circuit may be disposed thereon. Since magnitude of current transferred to the power amplifier circuit or current transferred through the power amplifier circuit is large, noise may be transferred to the speaker. The conductive pad separated from the ground may reduce noise around the speaker by limiting current flowing to the shield can or the case.

According to an embodiment, an antenna connected to the wireless communication circuitry may be disposed to face a sidewall of the electronic device 100.

According to an embodiment, an electronic device 100 is disclosed. The electronic device may include a speaker (e.g., the speaker 310 of FIG. 4). The electronic device may further include a printed circuit board (PCB) 150. The PCB may include an opening portion accommodating the speaker 310.

The electronic device may further include a case (e.g., the case 316 of FIG. 3) surrounding a rear side of the speaker and disposed on the PCB.

The PCB 150 may further include a conductive pad (e.g., the conductive pad 401 of FIG. 4) disposed along the opening portion (e.g., the opening portion 352 of FIG. 4), exposed to an outside of the PCB, and coupled to the case (e.g., the case 316 of FIG. 4).

The electronic device may further include conductive patterns disposed in the PCB and electrically disconnected from the conductive pad.

The conductive pad may be electrically disconnected from a ground portion of the electronic device electrically connected to the conductive patterns.

According to the above-described embodiment, the conductive patterns may limit a return current flowing through the conductive pattern from being transferred to a shield can through the conductive pad by being separated from the conductive pad. As the current flowing in the shield can is limited, current flowing around the speaker may be reduced. According to the reduction of the current flowing around the speaker, magnitude of a magnetic field formed around the speaker may be decreased, or the magnetic field may be removed. As noise caused by the magnetic field is reduced, quality of an audio signal of the speaker may be improved.

According to an embodiment, the PCB may further include a plurality of non-conductive layers (e.g., the non-conductive layer 421a, 421b, 421c, or 421d of FIG. 4) forming the substrate. The PCB may include other conductive patterns (e.g., the other conductive patterns 412a, 412b, 412c, and 412d of FIG. 4) disposed on respective ones of the plurality of non-conductive layers. The other conductive patterns may be electrically disconnected from the conductive pad.

According to the above-described embodiment, the other conductive patterns may limit a return current flowing through the other conductive patterns from being transferred to a shield can through the conductive pad by being separated from the conductive pad. As the current flowing to the shield can on the speaker is limited, influence of a magnetic field transferred to the speaker disposed below the shield can may be decreased.

According to an embodiment, the other conductive patterns may be disposed on respective ones of remaining non-conductive layers, among the plurality of non-conductive layers, other than a non-conductive layer close to the rear side of the speaker.

According to the above-described embodiment, the conductive patterns may be electrically disconnected from the conductive pattern by being disposed on another layer. By being separated from each other, the conductive patterns and the conductive pad may block current from flowing to the case, and generation of a magnetic field around the speaker may be reduced by the blocking of the current. The speaker may reduce noise by reducing an induced current of a coil generated by the magnetic field.

According to an embodiment, the other conductive patterns may be connected to the conductive patterns through a conductive via penetrating the plurality of non-conductive layers.

The at least one element may connect the conductive patterns connected to the other conductive patterns to the conductive pad to reduce current flowing from the component on the PCB to the rechargeable battery through the case and to cause the case to operate as a ground while the electronic device transmits a signal to an external electronic device.

According to the above-described embodiment, the pad may secure rigidity by being connected to the conductive portions. The conductive pad securing rigidity may maintain bonding force with the case. The conductive pad maintaining coupling with the case may prevent a return current from being transferred to the case through the conductive pad by being spaced apart from the conductive patterns. The limited current or the reduced current may decrease magnitude of a magnetic field around the speaker. Through the decreased magnetic field, an amount of an induced current in the speaker may be reduced, and audio quality of the speaker may be improved by the reduced induced current.

According to an embodiment, the speaker may be configured to provide an audio signal to an outside of the electronic device through an acoustic duct located in front of the speaker. The case may provide a resonance space 450 for the audio signal.

The electronic device according to the above-described embodiment may improve quality of an audio signal in a low frequency band of the speaker by including the resonance space. As a space between the case and the printed circuit board is sealed, the case may prevent sound leakage of an audio signal emitted from the speaker. According to the prevention of the sound leakage, magnitude of the audio signal may be maintained, and quality of the audio signal may be improved.

FIG. 8 is a block diagram illustrating an electronic device 801 in a network environment 800 according to various embodiments. Referring to FIG. 8, the electronic device 801 in the network environment 800 may communicate with an electronic device 802 via a first network 898 (e.g., a short-range wireless communication network), or at least one of an electronic device 804 or a server 808 via a second network 899 (e.g., a long-range wireless communication network). According to an embodiment, the electronic device 801 may communicate with the electronic device 804 via the server 808. According to an embodiment, the electronic device 801 may include a processor 820, memory 830, an input module 850, a sound output module 855, a display module 860, an audio module 870, a sensor module 876, an interface 877, a connecting terminal 878, a haptic module 879, a camera module 880, a power management module 888, a battery 889, a communication module 890, a subscriber identification module (SIM) 896, or an antenna module 897. In some embodiments, at least one of the components (e.g., the connecting terminal 878) may be omitted from the electronic device 801, or one or more other components may be added in the electronic device 801. In some embodiments, some of the components (e.g., the sensor module 876, the camera module 880, or the antenna module 897) may be implemented as a single component (e.g., the display module 860).

The processor 820 may execute, for example, software (e.g., a program 840) to control at least one other component (e.g., a hardware or software component) of the electronic device 801 coupled with the processor 820, and may perform various data processing or computation. According to an embodiment, as at least part of the data processing or computation, the processor 820 may store a command or data received from another component (e.g., the sensor module 876 or the communication module 890) in volatile memory 832, process the command or the data stored in the volatile memory 832, and store resulting data in non-volatile memory 834. According to an embodiment, the processor 820 may include a main processor 821 (e.g., a central processing unit (CPU) or an application processor (AP)), or an auxiliary processor 823 (e.g., a graphics processing unit (GPU), a neural processing unit (NPU), an image signal processor (ISP), a sensor hub processor, or a communication processor (CP)) that is operable independently from, or in conjunction with, the main processor 821. For example, when the electronic device 801 includes the main processor 821 and the auxiliary processor 823, the auxiliary processor 823 may be adapted to consume less power than the main processor 821, or to be specific to a specified function. The auxiliary processor 823 may be implemented as separate from, or as part of the main processor 821.

The auxiliary processor 823 may control at least some of functions or states related to at least one component (e.g., the display module 860, the sensor module 876, or the communication module 890) among the components of the electronic device 801, instead of the main processor 821 while the main processor 821 is in an inactive (e.g., sleep) state, or together with the main processor 821 while the main processor 821 is in an active state (e.g., executing an application). According to an embodiment, the auxiliary processor 823 (e.g., an image signal processor or a communication processor) may be implemented as part of another component (e.g., the camera module 880 or the communication module 890) functionally related to the auxiliary processor 823. According to an embodiment, the auxiliary processor 823 (e.g., the neural processing unit) may include a hardware structure specified for artificial intelligence model processing. An artificial intelligence model may be generated by machine learning. Such learning may be performed, e.g., by the electronic device 801 where the artificial intelligence is performed or via a separate server (e.g., the server 808). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 830 may store various data used by at least one component (e.g., the processor 820 or the sensor module 876) of the electronic device 801. The various data may include, for example, software (e.g., the program 840) and input data or output data for a command related thereto. The memory 830 may include the volatile memory 832 or the non-volatile memory 834.

The program 840 may be stored in the memory 830 as software, and may include, for example, an operating system (OS) 842, middleware 844, or an application 846.

The input module 850 may receive a command or data to be used by another component (e.g., the processor 820) of the electronic device 801, from the outside (e.g., a user) of the electronic device 801. The input module 850 may include, for example, a microphone, a mouse, a keyboard, a key (e.g., a button), or a digital pen (e.g., a stylus pen).

The sound output module 855 may output sound signals to the outside of the electronic device 801. The sound output module 855 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 860 may visually provide information to the outside (e.g., a user) of the electronic device 801. The display module 860 may include, for example, a display, a hologram device, or a projector and control circuitry to control a corresponding one of the display, hologram device, and projector. According to an embodiment, the display module 860 may include a touch sensor adapted to detect a touch, or a pressure sensor adapted to measure the intensity of force incurred by the touch.

The audio module 870 may convert a sound into an electrical signal and vice versa. According to an embodiment, the audio module 870 may obtain the sound via the input module 850, or output the sound via the sound output module 855 or a headphone of an external electronic device (e.g., an electronic device 802) directly (e.g., wiredly) or wirelessly coupled with the electronic device 801.

The sensor module 876 may detect an operational state (e.g., power or temperature) of the electronic device 801 or an environmental state (e.g., a state of a user) external to the electronic device 801, and then generate an electrical signal or data value corresponding to the detected state. According to an embodiment, the sensor module 876 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 877 may support one or more specified protocols to be used for the electronic device 801 to be coupled with the external electronic device (e.g., the electronic device 802) directly (e.g., wiredly) or wirelessly. According to an embodiment, the interface 877 may include, for example, a high definition multimedia interface (HDMI), a universal serial bus (USB) interface, a secure digital (SD) card interface, or an audio interface.

A connecting terminal 878 may include a connector via which the electronic device 801 may be physically connected with the external electronic device (e.g., the electronic device 802). According to an embodiment, the connecting terminal 878 may include, for example, an HDMI connector, a USB connector, an SD card connector, or an audio connector (e.g., a headphone connector).

The haptic module 879 may convert an electrical signal into a mechanical stimulus (e.g., a vibration or a movement) or electrical stimulus which may be recognized by a user via his tactile sensation or kinesthetic sensation. According to an embodiment, the haptic module 879 may include, for example, a motor, a piezoelectric element, or an electric stimulator.

The camera module 880 may capture a still image or moving images. According to an embodiment, the camera module 880 may include one or more lenses, image sensors, image signal processors, or flashes.

The power management module 888 may manage power supplied to the electronic device 801. According to an embodiment, the power management module 888 may be implemented as at least part of, for example, a power management integrated circuit (PMIC).

The battery 889 may supply power to at least one component of the electronic device 801. According to an embodiment, the battery 889 may include, for example, a primary cell which is not rechargeable, a secondary cell which is rechargeable, or a fuel cell.

The communication module 890 may support establishing a direct (e.g., wired) communication channel or a wireless communication channel between the electronic device 801 and the external electronic device (e.g., the electronic device 802, the electronic device 804, or the server 808) and performing communication via the established communication channel. The communication module 890 may include one or more communication processors that are operable independently from the processor 820 (e.g., the application processor (AP)) and supports a direct (e.g., wired) communication or a wireless communication. According to an embodiment, the communication module 890 may include a wireless communication module 892 (e.g., a cellular communication module, a short-range wireless communication module, or a global navigation satellite system (GNSS) communication module) or a wired communication module 894 (e.g., a local area network (LAN) communication module or a power line communication (PLC) module). A corresponding one of these communication modules may communicate with the external electronic device via the first network 898 (e.g., a short-range communication network, such as Bluetooth^{™}, wireless-fidelity (Wi-Fi) direct, or infrared data association (IrDA)) or the second network 899 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 892 may identify and authenticate the electronic device 801 in a communication network, such as the first network 898 or the second network 899, using subscriber information (e.g., international mobile subscriber identity (IMSI)) stored in the subscriber identification module 896.

The wireless communication module 892 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 892 may support a high-frequency band (e.g., the mmWave band) to achieve, e.g., a high data transmission rate. The wireless communication module 892 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 892 may support various requirements specified in the electronic device 801, an external electronic device (e.g., the electronic device 804), or a network system (e.g., the second network 899). According to an embodiment, the wireless communication module 892 may support a peak data rate (e.g., 20Gbps or more) for implementing eMBB, loss coverage (e.g., 864dB or less) for implementing mMTC, or U-plane latency (e.g., 0.5ms or less for each of downlink (DL) and uplink (UL), or a round trip of 8ms or less) for implementing URLLC.

The antenna module 897 may transmit or receive a signal or power to or from the outside (e.g., the external electronic device) of the electronic device 801. According to an embodiment, the antenna module 897 may include an antenna including a radiating element composed of a conductive material or a conductive pattern formed in or on a substrate (e.g., a printed circuit board (PCB)). According to an embodiment, the antenna module 897 may include a plurality of antennas (e.g., array antennas). In such a case, at least one antenna appropriate for a communication scheme used in the communication network, such as the first network 898 or the second network 899, may be selected, for example, by the communication module 890 (e.g., the wireless communication module 892) from the plurality of antennas. The signal or the power may then be transmitted or received between the communication module 890 and the external electronic device via the selected at least one antenna. According to an embodiment, another component (e.g., a radio frequency integrated circuit (RFIC)) other than the radiating element may be additionally formed as part of the antenna module 897.

According to various embodiments, the antenna module 897 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 801 and the external electronic device 804 via the server 808 coupled with the second network 899. Each of the electronic devices 802 or 804 may be a device of a same type as, or a different type, from the electronic device 801. According to an embodiment, all or some of operations to be executed at the electronic device 801 may be executed at one or more of the external electronic devices 802, 804, or 808. For example, if the electronic device 801 should perform a function or a service automatically, or in response to a request from a user or another device, the electronic device 801, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 801. The electronic device 801 may provide the outcome, with or without further processing of the outcome, as at least part of a reply to the request. To that end, a cloud computing, distributed computing, mobile edge computing (MEC), or client-server computing technology may be used, for example. The electronic device 801 may provide ultra low-latency services using, e.g., distributed computing or mobile edge computing. In another embodiment, the external electronic device 804 may include an internet-of-things (IoT) device. The server 808 may be an intelligent server using machine learning and/or a neural network. According to an embodiment, the external electronic device 804 or the server 808 may be included in the second network 899. The electronic device 801 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 840) including one or more instructions that are stored in a storage medium (e.g., internal memory 836 or external memory 838) that is readable by a machine (e.g., the electronic device 801). For example, a processor (e.g., the processor 820) of the machine (e.g., the electronic device 801) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a speaker;
a printed circuit board, PCB, including an opening portion accommodating the speaker;
an electronic component disposed on the PCB and adjacent to the speaker;
at least one element disposed on the PCB; and
a case surrounding a rear side of the speaker and disposed on the PCB,
wherein the PCB includes:
a conductive pad disposed along a peripheral portion of the opening portion of the PCB and coupled to the case, and
conductive patterns spaced apart from the conductive pad of the PCB and disposed on a layer of the PCB on which the conductive pad is disposed, and
wherein the at least one element connects the conductive patterns and the conductive pad for the case functioning as a ground.

2. The electronic device of claim 1,
wherein the speaker is configured to provide an audio signal to an outside of the electronic device through an acoustic duct located in front of the speaker, and
wherein the case provides a resonance space for the audio signal.

3. The electronic device of claim 1 or 2,
wherein the PCB includes:
a substrate including a plurality of non-conductive layers, and
other conductive patterns disposed on respective ones of the plurality of non-conductive layers.

4. The electronic device of claim 3,
wherein the conductive pad is disposed on a non-conductive layer, among the plurality of non-conductive layers, closest to the rear side of the speaker.

5. The electronic device of claim 3 or 4,
wherein the other conductive patterns are disposed on respective ones of remaining non-conductive layers, among the plurality of non-conductive layers, other than the non-conductive layer closest to the rear side of the speaker.

6. The electronic device of any one of claims 3 to 5,
wherein the other conductive patterns are connected to each other through conductive vias penetrating the plurality of non-conductive layers, and are spaced apart from the conductive pad.

7. The electronic device of any one of claims 1 to 6, further comprising a camera connected to the PCB,
wherein the speaker corresponds to a receiver configured to deliver an audio signal received through communication with an external electronic device, and is disposed adjacent to the camera.

8. The electronic device of any one of claims 1 to 7,
wherein a portion of a lateral side of the conductive pad is surrounded by a conductive thin film.

9. The electronic device of any one of claims 1 to 8,
wherein the PCB includes reinforcement patterns connected to the conductive pad through conductive vias and disposed in the PCB, and
wherein each of the reinforcement patterns is spaced apart from the conductive patterns.

10. The electronic device of any one of claims 1 to 9, further comprising at least one processor disposed on the PCB and operatively connected to the speaker.

11. The electronic device of any one of claims 1 to 10, further comprising a housing,
wherein the housing includes a support portion disposed in the housing and including an acoustic duct connected to an audio hole defined by a lateral side of the housing, and
wherein the speaker is disposed on the support portion in the housing.

12. The electronic device of any one of claims 1 to 11,
wherein the case is configured to reduce a current transferred from the conductive patterns to limit generation of a magnetic field caused by a current flowing along the case.

13. The electronic device of any one of claims 1 to 12,
wherein the PCB includes a portion disposed beside the opening portion and excluding the conductive patterns.

14. The electronic device of claim 13,
wherein the conductive patterns are disconnected from each other at the portion of the PCB.

15. The electronic device of any one of claims 1 to 14, further comprising:
wireless communication circuitry;
an antenna electrically connected to the wireless communication circuitry; and
a battery,
wherein the battery is electrically connected to a power amplifier circuit of the wireless communication circuitry through the conductive patterns of the PCB, and
wherein the antenna is disposed to face a sidewall of the electronic device.
